# EUROPÄISCHE PATENTANMELDUNG

(11) **EP 2 221 584 A2**
(43) Veröffentlichungstag der Anmeldung: **25.08.2010**
(21) Anmeldenummer: 10001661.7
(22) Anmeldetag: 18.02.2010
(51) Int. Cl.: G01D 4/00, G01R 21/133

(54) **Kommunikationsgerät für eine Stromzählanlage**

(30) Priorität: 19.02.2009 DE 102009009564
(71) Anmelder: Hager Electro GmbH & Co. KG, 66440 Blieskastel (DE)
(72) Erfinder: Hauck, Johannes, D-66440 Blieskastel (DE)
(74) Vertreter: Bernhardt, Reinold

(57) **Zusammenfassung**

Die Erfindung betrifft ein Kommunikationsgerät (10) für eine Stromzählanlage, insbesondere zur Fernübertragung von Daten zwischen der Stromzählanlage und einer Kommunikationseinrichtung des Stromversorgungsunternehmens. Erfindungsgemäß ist das Kommunikationsgerät (10) über eine zum Anschluss eines Stromzählers (2) vorgesehene Anschlusseinrichtung (5,15) mit der Stromzöhlanlage verbindbar.

## Beschreibung

Die Erfindung betrifft ein Kommunikationsgerät für eine Stromzählanlage, insbesondere zur Fernübertragung von Daten zwischen der Stromzählanlage und einer Kommunikationseinrichtung.

Ein Kommunikationsgerät solcher Art, das z.B. mit einer Kommunikationseinrichtung des Stromversorgungsunternehmens kommuniziert und unter anderem der Fernauslesung eines Stromzählers dient, geht aus der DE 102 61 206B4 hervor. Das in Verbindung mit einem elektronischen Stromzähler verwendete Kommunikationsgerät ist neben dem auf eine Tragplatte aufgesteckten Stromzähler angeordnet und auf einer Hutprofilträgerschiene montiert.

Der Erfindung liegt die Aufgabe zugrunde, ein neues Kommunikationsgerät der eingangs erwähnten Art zu schaffen, das sich mit geringem Montage- und Verdrahtungsaufwand in eine Stromzählanlage einbauen lässt.

Das diese Aufgabe lösende Kommunikationsgerät nach der Erfindung ist **dadurch gekennzeichnet, dass** es über eine zum Anschluss eines Stromzählers vorgesehene Anschlusseinrichtung mit der Stromzählanlage verbindbar ist.

Gemäß der Erfindung kann das Kommunikationsgerät, dem selbst keine Zählfunktion zukommt, zusammen mit wenigstens einem Stromzähler in eine mehrere Anschlusseinrichtungen für einen Stromzähler aufweisende Stromzählanlage eingebaut werden, wobei der Einbau des Kommunikationsgeräts die gleichen Arbeitsgänge wie die Zählerinstallation erfordert.

In der bevorzugten Ausführungsform der Erfindung weisen das Kommunikationsgerät und der Stromzähler übereinstimmende Mittel zur Verbindung des Kommunikationsgerätes bzw. Stromzählers mit der Stromzählanlage auf.

Vorzugsweise ist das Kommunikationsgerät elektrisch mit wenigstens einem zu der Anschlusseinrichtung hinführenden Phasenleiter und dem Neutralleiter verbindbar. Vorteilhaft kann in diesem Fall das Kommunikationsgerät über die genannten Leiter mit einer Betriebsspannung versorgt werden.

Bei dem Stromzähler handelt es sich vorzugsweise um einen elektronischen Stromzähler mit Kontaktelementen zur elektrischen Verbindung mit Phasenleitern und dem Neutralleiter. Wie das Kommunikationsgerät bezieht zweckmäßig auch der Stromzähler seine Betriebsspannung über einen herangeführten Phasenleiter und den Neutralleiter.

In einer Ausführungsform der Erfindung ist das Kommunikationsgerät zur Datenübertragung über die mit der Anschlusseinrichtung verbundenen Stromleitungen vorgesehen. Vorteilhaft bedarf es zur Datenfernübertragung keiner gesonderten Signalleitungen.

In einer bevorzugten Ausführungsform der Erfindung weisen das Kommunikationsgerät und der Stromzähler wenigstens anschlussseitig übereinstimmend ausgebildete Gehäuse auf, wobei von dem Gehäuse insbesondere Hakenfüße und Kontaktelemente für den Eingriff in Öffnungsschlitze in einer Trägerplatte der Anschlusseinrichtung vorstehen.

In weiterer Ausgestaltung der Erfindung ist das Kommunikationsgerät in der Verbindungsposition mit der Stromzählanlage, vorzugsweise in gleicher Weise wie der Stromzähler, arretier- und plombierbar.

Das Kommunikationsgerät kann zur Datenübertragung zwischen mehreren Stromzählern und der genannten Kommunikationseinrichtung vorgesehen sein.

Alternativ zu der oben erwähnten Datenübertragung durch Stromleiter kann das Kommunikationsgerät zur Datenfernübertragung über das Telefonfestnetz oder ein Funknetz vorgesehen sein, wobei z.B. ein zellulares Funknetz oder ein GPRS-Datennetz infrage kommt.

Das Kommunikationsgerät kann in Funkverbindung mit einem oder mehreren Stromzählern einer Stromzählanlage stehen. Insbesondere können sämtliche Stromzähler einer Stromzählanlage und ggf. weiterer Anlagen über ein einziges Kommunikationsgerät mit der Kommunikationseinrichtung des Stromversorgungsunternehmens verbunden sein.

Die Erfindung wird nachfolgend anhand eines Ausführungsbeispiels und der beiliegenden, sich auf dieses Ausführungsbeispiel beziehenden Zeichnungen näher erläutert. Es zeigen:
- Fig. 1: eine Stromzählanlage mit einem Kommunikationsgerät nach der Erfindung,
- Fig. 2: das in der Stromzählanlage von Fig. 1 verwendete Kommunikationsgerät in einer Ansicht von hinten, und
- Fig. 3: das Kommunikationsgerät von Fig. 2 in einer Teilansicht von der Seite.

Eine Stromzählanlage weist mehrere Anschlussfelder 1 zur Aufnahme von je zwei elektronischen Stromzählern 2 auf. Zwischen einem unteren Anschlussraum 3 und einem oberen Anschlussraum 4 des jeweiligen Anschlussfeldes 1 befinden sich zwei, eine Tragplatte 5 umfassende Anschlusseinrichtungen für die Stromzähler.

Die Stromzähler 2 weisen je ein Gehäuse auf, von dessen Rückseite 6 am Rand vier flache Hakenfüße 7 und weiter innen Anschlusskontakte 8 entsprechend drei Stromphasen und dem Neutralleiter vorstehen. Beim Anschluss wird der Stromzähler 2 auf die Tragplatte 5 aufgesetzt, wobei die Hakenfüße 7 und Anschlusskontakte 8 in Schlitzöffnungen 15 in der Tragplatte 5 eingreifen. Nach Verschiebung des Stromzählers 1 auf der Tragplatte 5 hintergreifen dann die Hakenfüße 7 die Tragplatte und die Anschlusskontakte 8 stehen in elektrischer Verbindung mit entsprechenden, hinter der Tragplatte 5 angeordneten Anschlusselementen (nicht gezeigt). In der Anschlussposition lässt sich der Stromzähler mit Hilfe eines plombierbaren Stiftes 9 arretieren.

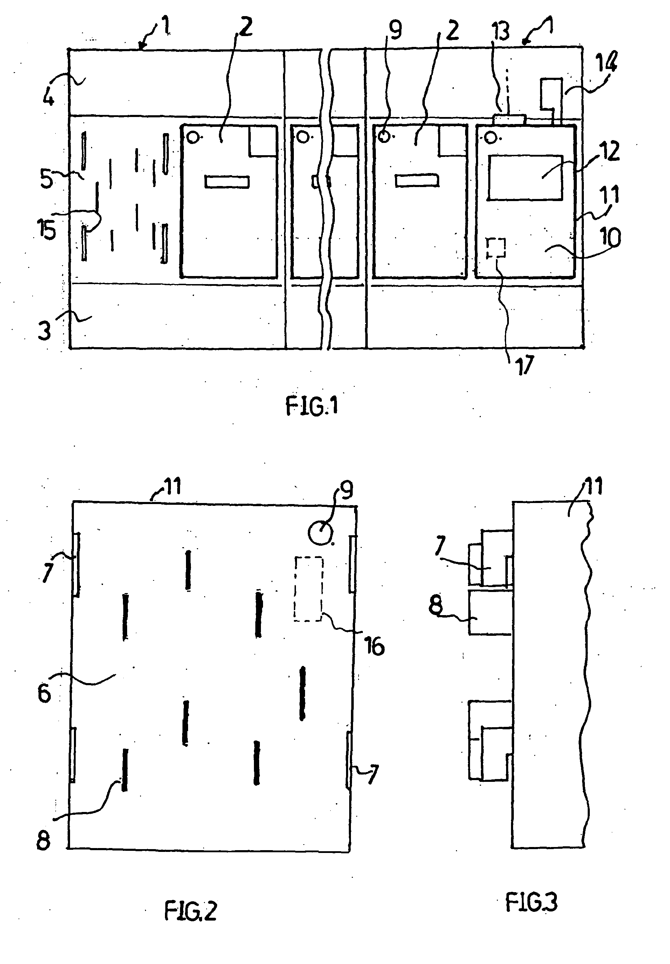

An der äußersten rechten Anschlusseinrichtung der Stromzählanlage von Fig. 1 ist kein Stromzähler 1 sondern ein Kommunikationsgerät 10 angeschlossen. Das Kommunikationsgerät 10 weist ein mit dem Gehäuse der Stromzähler 1 weitgehend übereinstimmendes Gehäuse 11 auf, wobei insbesondere die in Fig. 2 und 3 gezeigten Bereiche identisch zu den betreffenden Bereichen der Stromzählergehäuse ausgebildet sind. Das Kommunikationsgerät 10 lässt sich daher in gleicher Weise wie die Stromzähler 1 über die betreffende Anschlusseinrichtung an der Stromzählanlage anbringen.

Wie die Stromzähler 1 weist auch das Kommunikationsgerät 10 einen plombierbaren Arretierungsstift 9 auf. Äußerlich unterscheidet sich das Kommunikationsgerät 10 von den Stromzählern 1 in dem gezeigten Ausführungsbeispiel vor allem durch ein größeres Display 12.

Das Kommunikationsgerät 10 überträgt Daten von den Stromzählern 1 zu einer Kommunikationseinrichtung z.B. des die Stromzählanlage betreibenden Stromversorgungsunternehmens oder des Stromverbrauchers und umgekehrt von der Kommunikationseinrichtung zu den Stromzählern. Im Rahmen einer solchen Datenübertragung erfolgt z.B. eine Fernauslesung der Stromzähler, eine Tarifumstellung oder die Übersendung eines Abschaltsignals.

Das Kommunikationsgerät 10 ließe sich mit den einzelnen Stromzählern 1 über Datenleitungen verbinden und könnte entsprechende Anschlüsse aufweisen, wobei solche Anschlüsse 16 z.B. an der der Zählertragplatte 5 zugewandten Rückseite 6 angeordnet und die Datenleitungen verdeckt durch die Tragplatten verlegt sein könnten. Alternativ wäre eine Datenverbindung zwischen den einzelnen Stromzählern 1 und dem Kommunikationsgerät 10 per Funk oder über die sowohl an den Stromzähler als auch das Kommunikationsgerät angeschlossenen Stromleitungen möglich.

Der Datenverkehr zwischen dem Kommunikationsgerät 10 und der genannten Kommunikationseinrichtung beim Stromversorgungsunternehmen kann über die genannten Stromleitungen, über das Telefonfestnetz oder per Funk erfolgen. In letzterem Fall kommen sowohl zellulare Funknetze als auch GPRS-Datennetze in Betracht. Entsprechend weist das Kommunikationsgerät 10 in dem gezeigten Ausführungsbeispiel einen Ausgang 13 für eine Verbindung mit dem Telefonfestnetz sowie einen Ausgang zum Anschluss einer Antenne 14 auf. Eine Datenschnittstelle 17 kann z.B. auch an der Vorderseite des Kommunikationsgerätes 10 vorgesehen sein.

## Patentansprüche

1. Kommunikationsgerät (10) für eine Stromzählanlage, insbesondere zur Fernübertragung von Daten zwischen der Stromzählanlage und einer Kommunikationseinrichtung,
**dadurch gekennzeichnet,**
**dass** das Kommunikationsgerät (10) über eine zum Anschluss eines Stromzählers (2) vorgesehene Anschlusseinrichtung (5,15) mit der Stromzählanlage verbindbar ist.

2. Kommunikationsgerät nach Anspruch 1,
**dadurch gekennzeichnet,**
**dass** das Kommunikationsgerät (10) und der Stromzähler (2) übereinstimmende Mittel (7,8) zur Verbindung des Kommunikationsgerätes (10) bzw. Stromzählers (2) mit der Stromzählanlage über die Anschlusseinrichtung (5,15) aufweisen.

3. Kommunikationsgerät nach Anspruch 1 oder 2,
**dadurch gekennzeichnet,**
**dass** der Stromzähler (2) ein elektronischer Stromzähler mit einem Kontaktelementen (8) zur elektrischen Verbindung des Stromzählers (2) mit Phasenleitern und dem Neutralleiter ist.

4. Kommunikationsgerät nach einem der Ansprüche 1 bis 3,
**dadurch gekennzeichnet,**
**dass** das Kommunikationsgerät (10) elektrisch mit wenigstens einem zu der Anschlusseinrichtung hinführenden Phasenleiter und dem Neutralleiter verbindbar ist.

5. Kommunikationsgerät nach einem der Ansprüche 1 bis 4,
**dadurch gekennzeichnet,**
**dass** das Kommunikationsgerät (10) zur Datenübertragung über die mit der Anschlusseinrichtung (5,15) verbundenen Stromleitungen vorgesehen ist.

6. Kommunikationsgerät nach einem der Ansprüche 1 bis 5,
**dadurch gekennzeichnet,**
**dass** das Kommunikationsgerät (10) und der Stromzähler (2) wenigstens anschlussseitig übereinstimmend ausgebildete Gehäuse (11) aufweisen.

7. Kommunikationsgerät nach Anspruch 6,
**dadurch gekennzeichnet,**
**dass** von dem Gehäuse (11) Hakenfüße (7) und Kontaktelemente (8) für den Eingriff in Öffnungsschlitze (15) in einer Tragplatte (5) der Anschlusseinrichtung (5,15) vorstehen.

8. Kommunikationsgerät nach einem der Ansprüche 1 bis 7,
**dadurch gekennzeichnet,**
**dass** das Kommunikationsgerät (10) in der Verbindungsposition mit der Stromzählanlage arretier- und plombierbar ist, vorzugsweise in gleicher Weise wie der Stromzähler (2).

9. Kommunikationsgerät nach einem der Ansprüche 1 bis 8,
**dadurch gekennzeichnet,**
**dass** das Kommunikationsgerät (10) zur Datenfernübertragung zwischen mehreren Stromzählern (2) und der genannten Kommunikationseinrichtung vorgesehen ist.

10. Kommunikationsgerät nach einem der Ansprüche 1 bis 9,
**dadurch gekennzeichnet,**
**dass** das Kommunikationsgerät (10) zur Datenfernübertragung über das Telefonfestnetz, ein zellulares Funknetz oder/und ein GPRS-Datennetz vorgesehen ist.

11. Kommunikationsgerät nach einem der Ansprüche 1 bis 10,
**dadurch gekennzeichnet,**
**dass** das Kommunikationsgerät (10) in Funkverbindung mit mehreren Stromzählern (2) der Stromzählanlage steht.
